# EUROPÄISCHE PATENTSCHRIFT

(11) **EP 0 813 762 B1**
(45) Veröffentlichungstag und Bekanntmachung des Hinweises auf die Patenterteilung: **23.09.1998**
(21) Anmeldenummer: 96907334.5
(22) Anmeldetag: 01.03.1996
(51) Int. Cl.: H02B 1/30

(54) **SCHALTSCHRANK MIT SCHRANKTÜR UND DACHHAUBE**
SWITCHGEAR CABINET WITH DOOR AND CAP
ARMOIRE DE DISTRIBUTION AVEC PORTE ET CAPOT DE COUVERTURE

(30) Priorität: 07.03.1995 DE 19507731
(43) Veröffentlichungstag der Anmeldung: 29.12.1997
(73) Patentinhaber: Rittal-Werk Rudolf Loh GmbH & Co. KG, 35745 Herborn (DE)
(72) Erfinder: ZACHRAI, Jürgen, D-35690 Dillenburg (DE)
(74) Vertreter: Fleck, Hermann-Josef, Dr.-Ing.
(86) Internationale Anmeldenummer: EP9600868
(87) Internationale Veröffentlichungsnummer: WO9627933

(56) Entgegenhaltungen:
- DE-A- 2 656 446
- DE-U- 8 130 651

## Beschreibung

Die Erfindung betrifft einen Schaltschrank mit Schranktür, bei dem auf der Oberseite eine Dachhaub befestigt ist (vgl DE-A-26 56 446).

Bei bekannten Schaltschränken dieser Art dient die Dachhaube in erster Linie zur Abdeckung eines auf dem Schaltschrank befestigten Klimagerätes oder dgl. Die Dachhaube wird dabei über Schnellverschlüsse in der Schließstellung gehalten, wobei die Teile der Schnellverschlüsse auf dem Schaltschrank und der Dachhaube befestigt sind.

Es ist Aufgabe der Erfindung, einen Schaltschrank der eingangs erwähnten Art zu schaffen, bei dem die Dachhaube auf einfachste Weise auf dem Schaltschrank angebracht werden kann.

Diese Aufgabe wird nach der Erfindung dadurch gelöst, daß die Dachhaube aus einem mit der Oberseite des Schaltschrankes verbundenen Unterteil und einem das Unterteil überdeckenden Dachteil besteht, daß das Dachteil auf seiner Rückseite mit dem Unterteil durch Steck- oder Scharnierverbindungen mit dem Unterteil verbunden ist, und daß das Dachteil auf der Vorderseite mit Haltelaschen versehen ist, die in der Schließstellung von Dachteil und Schranktür von einer Abkantung der Schranktür übergriffen und gehalten sind.

Die aus Unterteil und Dachteil bestehende Dachhaube kann bei geöffneter Schranktür geöffnet werden, wobei das Dachteil über die Steck- oder Scharnierverbindungen auf der Rückseite hochgeklappt werden kann. Ist das Dachteil auf dem Unterteil in Schließstellung gebracht, dann wird bei geschlossener Schranktür über die Haltelaschen das Dachteil in der Schließstellung gehalten. Die Haltelaschen des geschlossenen Dachteils ragen so in den Schwenkbereich der Schranktür, daß deren Abkantung die Haltelaschen übergreift. Bei geöffneter Schranktür kann im Falle der rückseitigen Steckverbindungen das Dachteil auch leicht von dem Unterteil gelöst werden.

Nach einer Ausgestaltung ist vorgesehen, daß das Unterteil rahmenartig ausgebildet und in den Seitenwänden mit Lüftungsschlitzen versehen ist. In der Ausgestaltung eignet sich die Dachhaube vorteilhafterweise als Aufnahme für ein Klimagerät oder dgl.

Ist dabei vorgesehen, daß das Dachteil in der Schließstellung mit seinen Seitenwänden die Seitenwände des Unterteils im Abstand überdeckt, dann wird die Belüftung der Dachhaube auch in der Schließstellung des Dachteils nicht beeinträchtigt.

Um evtl. auf das Dachteil gelangendes Wasser leicht abzuführen, sieht eine weitere Ausgestaltung vor, daß das Dachteil nach vorne und nach hinten geneigte Dachabschnitte aufweist.

Die Ausgestaltung des Unterteils ist so vorgenommen, das das Unterteil der Dachhaube zumindest an der vorderen und hinteren Seitenwand mit abgekanteten Stegen versehen ist, die zur Auflage des Dachteils und zur Befestigung des Unterteils auf der Oberseite des Schaltschrankes dienen.

Nach einer vorteilhaften Ausgestaltung ist weiterhin vorgesehen, daß die seitlichen Seitenwände des Dachteils in der Schließstellung die Seitenwände des Schaltschrankes im Abstand teilweise überdecken, um den seitlichen Übergang zwischen Schaltschrank und Dachhaube abzudecken.

Die Erfindung wird anhand eines in den Zeichnungen dargestellten Ausführungsbeispiels näher erläutert. Es zeigen:
- Fig. 1: in Perspektive die Oberseite eines Schaltschrankes mit aufgebauter Dachhaube und
- Fig. 2: eine Teilansicht mit dem Zusammenwirken von Schranktür und Dachteil zum Festlegen der Schließstellung der Dachhaube.

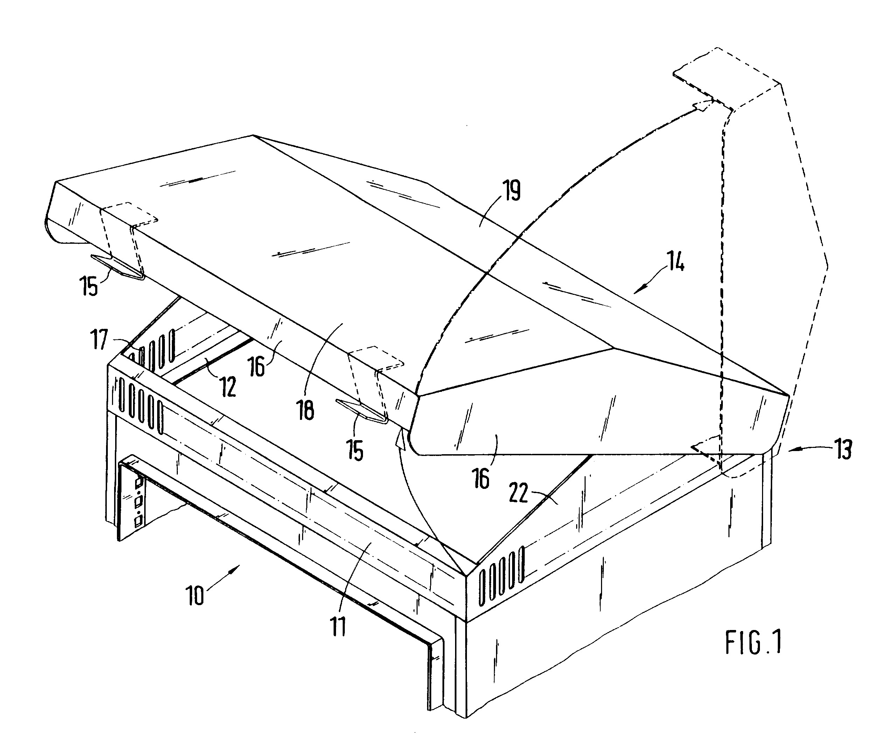

In Fig. 1 ist die Oberseite eines Schaltschrankes 10 dargestellt, dessen Seiten mit Wandelementen abgedeckt sind. Die Deckseite ist mit einer Deckwand verschlossen, wenn die aufgesetzte Dachhaube nur als Aufnahmeraum für Zubehörteile und dgl. verwendet wird. Dient die Dachhaube jedoch zur Aufnahme eines Klimagerätes oder dgl., dann ist die Deckwand des Schaltschrankes 10 mit Durchbrüchen versehen, über die die Luft aus dem Schaltschrank abgesaugt und die gekühlte Luft dem Schaltschrank zugeführt werden.

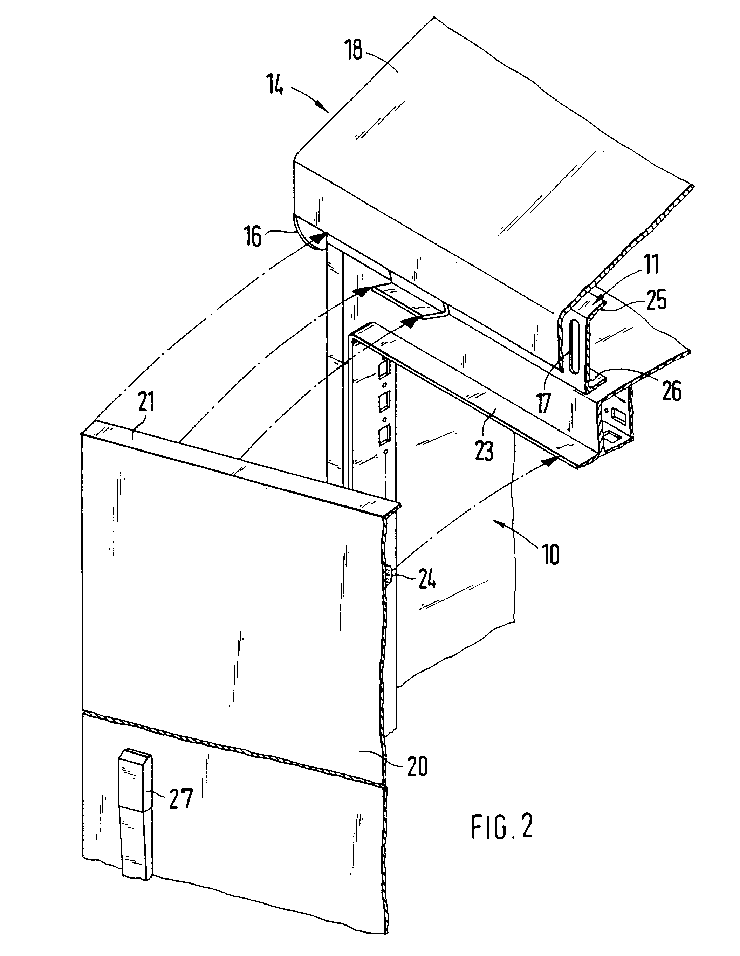

Die Dachhaube besteht aus einem rahmenartigen Unterteil 11, dessen Seitenwände 22 bündig mit den Außenseiten des Schaltschrankes 10 abschließen und mit Lüftungsschlitzen 17 versehen sind. Die Seitenwände 22 tragen nach innen gerichtete Stege 25 und 26, wie der Fig. 2 zu entnehmen ist, die als Auflage für das Dachteil 14 und zur Befestigung des Unterteils 11 auf dem Schaltschrank 10 dienen.

Auf der Rückseite des Unterteils 11 ist über Steck- oder Scharnierverbindungen 13 das Dachteil 14 am Unterteil 11 so angebracht, daß es hochgeklappt werden kann, wie in Fig. 1 angedeutet ist. Die vordere Seitenwand 16 des Dachteils 14 trägt abstehende Haltelaschen 15, die in der Schließstellung des Dachteils 14 so in den Schwenkbereich der mit Abkantungen 21 versehenen Schranktür 20 ragen, daß sie in der Schließstellung der Schranktür 20 von der Abkantung 21 übergriffen werden. Das Dachteil 14 wird so in seiner Schließstellung gehalten und zwar nur solange die Schranktür 20 sich in der Schließstellung befindet. Die Schranktür 20 trägt auf der Innenseite Dichtungselemente 24, die in der Schließstellung mit einem Dichtungssteg 23 des Schaltschrankes 10 die Abdichtung der offenen Schrankvorderseite übernehmen. Die Schranktür 20 wird in der Schließstelllung mittels eines Schlosses 25 abgeschlossen. Die seitlichen Seitenwände 16 des Dachteils 14, das mit nach vorne und nach hinten abfallenden Dachabschnitten 18 und 19 versehen ist, überdecken im Abstand die Seitenwände 22 des Unterteils 11 und auch die Seitenwände des Schaltschrankes zum Teil. Auf diese Weise wird die Belüftung der Dachhaube auch in der Schließstellung nicht beeinträchtigt, der Übergang zwischen dem Schaltschrank 10 und dem Unterteil 11 der Dachhaube jedoch geschützt.

Der Schaltschrank 10 selbst kann ein Rahmengestell aufweisen, das aus Rahmenschenkeln zusammengesetzt und mittels Wandelementen abgdeckt ist. Die Rahmenschenkel können aber auch zum Teil an den Wandelementen abgekantet sein. In jedem Fall sind die Rahmenschenkel mit Reihen von Befestigungsaufnahmen und/oder Befestigungsbohrungen versehen.

Der Zugang zu den in der Dachhaube untergebrachten Einbauten, Einrichtungen und dgl. wird dadurch noch erleichtert, daß das Dachteil 14 im geöffneten Zustand arretierbar ist. Das Dachteil 14 behält dann die Öffnungsstellung bei und braucht nicht gehalten zu werden.

## Patentansprüche

1. Schaltschrank mit Schranktür (20), bei dem auf der Oberseite eine Dachhaube befestigt ist,
dadurch gekennzeichnet,
daß die Dachhaube aus einem mit der Oberseite des Schaltschrankes (10) verbundenen Unterteil (11) und einem das Unterteil (11) überdeckenden Dachteil (14) besteht,
daß das Dachteil (14) auf seiner Rückseite mit dem Unterteil durch Steckoder Scharnierverbindungen (13) mit dem Unterteil (11) verbunden ist, und
daß das Dachteil (14) auf der Vorderseite mit Haltelaschen (15) versehen ist,
die in der Schließstellung von Dachteil (14) und Schranktür (20) von einer Abkantung (21) der Schranktür (20) übergriffen und gehalten sind.

2. Schaltschrank nach Anspruch 1,
dadurch gekennzeichnet,
daß das Unterteil (11) rahmenartig ausgebildet und in den Seitenwänden (22) mit Lüftungsschlitzen (17) versehen ist.

3. Schaltschrank nach Anspruch 1 oder 2,
dadurch gekennzeichnet,
daß das Dachteil (14) in der Schließstellung mit seinen Seitenwänden (16) die Seitenwände (22) des Unterteils (11) im Abstand überdeckt.

4. Schaltschrank nach einem der Ansprüche 1 bis 3,
dadurch gekennzeichnet,
daß das Dachteil (14) nach vorne und nach hinten geneigte Dachabschnitte (18,19) aufweist.

5. Schaltschrank nach einem der Ansprüche 1 bis 4,
dadurch gekennzeichnet,
daß die Dachhaube eine Aufnahmeraum für ein Klimagerät oder dgl. bildet, wobei die Deckwand des Schaltschrankes mit Durchbrüchen versehen ist.

6. Schaltschrank nach einem der Ansprüche 1 bis 5,
dadurch gekennzeichnet,
daß das Unterteil (11) der Dachhaube zumindest an der vorderen und hinteren Seitenwand (22) mit abgekanteten Stegen (25,26) versehen ist, die zur Auflage des Dachteils (14) und zur Befestigung des Unterteils (11) auf der Oberseite des Schaltschrankes dienen.

7. Schaltschrank nach einem der Ansprüche 1 bis 6,
dadurch gekennzeichnet,
daß die seitlichen Seitenwände (16) des Dachteils (14) in der Schließstellung die Seitenwände des Schaltschrankes im Abstand teilweise überdecken.

8. Schaltschrank nach einem der Ansprüche 1 bis 7,
dadurch gekennzeichnet,
daß das Dachteil (14) im geöffneten Zustand arretierbar ist.

## Claims

1. Switchgear cabinet with cabinet door (20), wherein a top cover is mounted on the upper side, characterised in that the top cover comprises a lower portion (11), which is connected to the upper side of the switchgear cabinet (10), and a top portion (14), which covers the lower portion (11), in that, on its rear side, the top portion (14) is connected to the lower portion by plug-in or hinge connections (13) with the lower portion (11), and in that the top portion (14) is provided, on the front side, with retaining lugs (15), which are overlapped and retained by a bent-over portion (21) of the cabinet door (20) when the top portion (14) and cabinet door (20) are in the closed position.

2. Switchgear cabinet according to claim 1, characterised in that the lower portion (11) has a frame-like configuration and is provided with ventilation slots (17) in the side walls (22).

3. Switchgear cabinet according to claim 1 or 2, characterised in that, in the closed position, the top portion (14) covers the side walls (22) of the lower portion (11) with its side walls (16) with a spacing therebetween.

4. Switchgear cabinet according to one of claims 1 to 3, characterised in that the top portion (14) has forwardly and rearwardly inclined top portions (18,19).

5. Switchgear cabinet according to one of claims 1 to 4, characterised in that the top cover forms a receiving chamber for the accommodation of an air-conditioning apparatus or the like, the cover wall of the switchgear cabinet being provided with openings.

6. Switchgear cabinet according to one of claims 1 to 5, characterised in that the lower portion (11) of the top cover is provided with bent-over webs (25,26), at least on the front and rear side walls (22), said webs being used to support the top portion (14) and to secure the lower portion (11) on the upper side of the switchgear cabinet.

7. Switchgear cabinet according to one of claims 1 to 6, characterised in that, in the closed position, the lateral side walls (16) of the top portion (14) partially cover the side walls of the switchgear cabinet with a spacing therebetween.

8. Switchgear cabinet according to one of claims 1 to 7, characterised in that the top portion (14) can be locked in position in the opened state.

## Revendications

1. Armoire de distribution avec porte (20), à laquelle est attachée, côté haut, un capot de couverture,
caractérisée
en ce que le capot de couverture est constitué par un élément inférieur (11) relié au côté supérieur de l'armoire de distribution (10) et par un élément de recouvrement (14) qui recouvre l'élément inférieur (11),
en ce que le l'élément de recouvrement (14) est, côté arrière, relié par des liaisons à enfichage ou à charnières (13) à l'élément inférieur, et en ce que l'élément de recouvrement (14) est à l'avant doté de pattes de fixation (15), qui dans la position de fermeture de l'élément de recouvrement (14) et de la porte (20) de l'armoire sont chevauchées et retenues par une partie coudée (21) de la porte (20) de l'armoire.

2. Armoire de distribution suivant la revendication 1, caractérisée
en ce que l'élément inférieur (11) est en forme de cadre et présente des fentes de ventilation (11) dans les parois latérales (22).

3. Armoire de distribution suivant la revendication 1 ou 2,
caractérisée en ce que dans la position de fermeture, l'élément de recouvrement (14) recouvre à une certaine distance par ses parois latérales (16) les parois latérales (22) de l'élément inférieur (11).

4. Armoire de distribution suivant l'une quelconque des revendications de 1 à 3,
caractérisée
en ce que l'élément de recouvrement (14) présente des portions de couverture (18, 19) inclinées vers l'avant et vers l'arrière.

5. Armoire de distribution suivant l'une quelconque des revendications de 1 à 4,
caractérisée
en ce que le capot de couverture constitue un emplacement pour un appareil de climatisation ou similaire et en ce que la paroi de couverture de l'armoire de distribution présente des percements.

6. Armoire de distribution suivant l'une quelconque des revendications de 1 à 5,
caractérisée
en ce que l'élément inférieur (11) du capot de couverture est, au moins sur la paroi latérale avant et arrière (22), doté barrettes cintrées (25, 26) qui servent d'appui pour l'élément de recouvrement (14) et à la fixation de l'élément inférieur (11) à la paroi supérieure de l'armoire de distribution.

7. Armoire de distribution suivant l'une quelconque des revendications de 1 à 6,
caractérisée
en ce que dans la position de fermeture, les parois latérales (16) de l'élément de recouvrement (14) recouvrent partiellement et à distance les parois latérales de l'armoire de distribution.

8. Armoire de distribution suivant l'une quelconque des revendications de 1 à 6,
caractérisée
en ce que l'élément de recouvrement (14) peut être bloqué en position d'ouverture.
